# EUROPEAN PATENT APPLICATION

(11) **EP 1 056 197 A2**
(43) Date of publication of application: **29.11.2000**
(21) Application number: 00111380.2
(22) Date of filing: 26.05.2000
(51) Int. Cl.: H03G 3/00

(54) **Gain Control Circuit**

(30) Priority: 28.05.1999 JP 15008299
(71) Applicant: MATSUSHITA ELECTRIC INDUSTRIAL CO., LTD., Kadoma-shi, Osaka-fu 571 (JP)
(72) Inventor: Takeyama, Kazuhiko, Toyama-shi, Toyama 930-0835 (JP); Ikeda, Kazuhiko, Mattou-shi, Tshikawa 924-0068 (JP); Nagayam, Toshihiro, Kanazawa-shi, Ishikawa 920-3115 (JP); Morino, Takayoshi, Yokosuka-shi, Kanagawa 239-0806 (JP)
(74) Representative: Grünecker, Kinkeldey, Stockmair & Schwanhäusser Anwaltssozietät

(57) **Abstract**

A gain control circuit 9 comprises gain controllers 2, 3 and a gain control signal generator 1a. Temperature characteristics of the gain of the controllers 2, 3 vary depending on the amount of a circuit gain control signal. The gain control signal generator 1a outputs gain control signals for controlling the gain of gain controllers 2, 3. Since gain controllers 2, 3 are connected in serial form and a predetermined offset to gain control signals 5, 6 is given, it has become possible to simply configure a gain control circuit having a wide dynamic range and good temperature characteristics.

## Description

### BACKGROUND OF THE INVENTION

The present invention relates to a gain control circuit mainly used for telecommunications apparatus; a receiver and a transmitter using the gain control circuit; and radio communications apparatus and a radio communications system using the receiver and a transmitter. The invention is especially intended to provide a gain control circuit having a wide dynamic range, good temperature characteristics, and a high gain control accuracy via a simple configuration.

In a recent mobile telecommunications system, the code division multiple access (CDMA) scheme is generally used. A transmitter or receiver in such a telecommunications system generally requires a wide dynamic range. For example, a base station requires a dynamic range of some 80dB.

As a gain control circuit having such a wide dynamic range, there is known a circuit having a plurality of variable gain amplifier in an RF circuit and an IF circuit (a multi-stage AGC circuit) as disclosed in Japanese Patent Publication No. 9-260982. There is also known a circuit using an amplifier and a variable attenuator of the same frequency band (a switch-controlled attenuator circuit), as disclosed in Japanese Patent Publication No. 9-116360.

In such a mobile telecommunications system, especially in base station apparatus, it is required to perform the input level detection of a receiver.

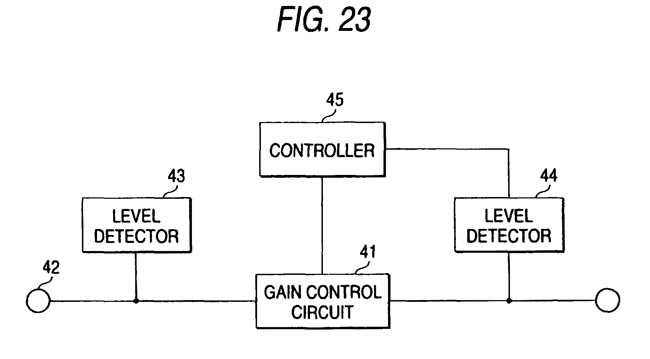

Conventionally, there is known a circuit of the form (separation scheme) shown in Fig. 23 as a gain control circuit performing the operation to detect the input level and to provide a constant output level (AGC operation).

In Fig. 23, a gain control circuit 41 operates so as to arbitrarily change the level of the signal input from an input pin 42. A level detector 43 operates so as to detect the input level of the gain control circuit 41. A level detector 44 operates so as to detect the output level of the gain control circuit 41. A controller 45 makes control to provide a constant output of the gain control circuit 41, by controlling the gain control circuit 41 based on the detection signal from the level detector 45. A gain control circuit of such a configuration is characterized that it uses two level detectors. The circuit has a temperature compensation feature and can perform input level detection and AGC operation.

In a mobile telecommunications system performing gain control, there is also known a scheme for performing level detection according to the gain control amount of the gain control circuit. This scheme requires a high gain control accuracy is required over a wide range of temperatures.

As a gain control circuit having the temperature compensation feature, there is conventionally known a circuit having a ramp critical point in control voltage characteristics (critical point -circuit), as disclosed in Japanese Patent Publication No. 8-32357. There is also known a circuit which uses a PIN diode as a gain control circuit as disclosed in Japanese Patent Publication NO. 10-32442.

The above-mentioned conventional multi-stage AGC circuit or switch-controlled attenuator circuit has a problem that temperature compensation is not easily provided. The above separation scheme has a problem of a larger circuit size. The critical point circuit has a problem that a wide dynamic range is not secured.

When the above gain control circuit having a PIN diode is used as a receiver/transmitter of a mobile communications system, there occurs a problem that temperature characteristics of the gain vary depending on the amount of a circuit gain control signal, thus degrading the gain control accuracy.

### SUMMARY OF THE INVENTION

The invention is intended to solve such problems and more specifically aims at providing a gain control circuit wherein a circuit having an wide dynamic range, good temperature characteristics, and a high gain control accuracy can be provided via a simple configuration; a receiver and a transmitter using the gain control circuit; and radio communications apparatus and a radio communications system using the receiver and a transmitter.

In order to solve the above problems, the invention provides a gain control circuit, a receiver and a transmitter using the gain control circuit, and radio communications apparatus and a radio communications system using the receiver and a transmitter, wherein the gain control circuit comprises: a plurality of gain controllers whose temperature characteristics of the gain vary depending on the amount of a circuit gain control signal; and a gain control signal generator for outputting a plurality of different gain control signals for controlling the gain of each gain controller, wherein the plurality of gain controllers are connected serially, and a predetermined offset is given to the plurality of gain control signals, so that the gain of the gain controller in the preceding stage is set lower than the gain of the gain controller in the subsequent stage or so that the gain of the gain controller in the subsequent stage is set lower than the gain of the gain controller in the preceding stage.

According to the invention, a circuit having a wide dynamic range, good temperature characteristics, and a high gain control accuracy can be provided via a simple configuration.

The first aspect of the invention is a gain control circuit, characterized in that the gain control circuit comprises a plurality of gain controllers whose temperature characteristics of the gain vary depending on the amount of a circuit gain control signal and a gain control signal generator for outputting a plurality of different gain control signals for controlling the gain of each gain controller, serially connects the plurality of gain controllers, and gives a predetermined offset to the plurality of gain control signals. This aspect has an effect of providing via a simple configuration a gain control circuit having a wide dynamic range and good temperature characteristics.

The second aspect of the invention is a gain control circuit, characterized in that the circuit serially comprises a signal processor circuit outputting different amount of distortion depending on the input level between a plurality of serially connected gain controllers and configured to set the gain of the gain controller in the preceding stage of the signal processor circuit lower than the gain of the gain controller in the subsequent stage of the signal processor circuit. Especially, this aspect has an effect of providing via a simple configuration a gain control circuit having a wide dynamic range, a high IIP3 (input intercept point off tertiary distortion) and good temperature characteristics.

The third aspect of the invention is a gain control circuit, characterized in that the circuit serially comprises a signal processor circuit for level processing between a plurality of serially connected gain controllers and configured to set via a gain control signal generator the gain of the gain controller in the subsequent stage of the signal processor circuit lower than the gain of the gain controller in the preceding stage of the signal processor circuit. Especially, this aspect has an effect of providing via a simple configuration a gain control circuit having a wide dynamic range, a low noise figure and good temperature characteristics.

The fourth aspect of the invention is a gain control circuit, characterized in that the circuit serially comprises a signal processor circuit which has a gain and which generates different amount of distortion depending on the input level between a plurality of serially connected gain controllers and a control signal switching section for switching between setting the gain control signal output from the gain control signal generator so that the gain of the gain controller in the preceding stage of the signal processor circuit becomes lower than the gain of the gain controller in the subsequent stage of the signal processor circuit, and setting the gain control signal output from the gain control signal generator so that the gain of the gain controller in the subsequent stage of the signal processor circuit becomes lower than the gain of the gain controller in the preceding stage of the signal processor circuit. Especially, this aspect has an effect of providing via a simple configuration a gain control circuit enabling IIP3 and noise figure to be optimized, and having a wide dynamic range and good temperature characteristics.

The fifth aspect of the invention is a gain control circuit, characterized in that the circuit comprises a temperature sensing circuit whose characteristics vary with temperatures and that the gain control signal of the gain control signal generator varies with the variation in the output signal of the temperature sensing circuit. Especially, this aspect has an effect of providing via a simple configuration a gain control circuit having a wide dynamic range and good temperature characteristics, by correcting the temperature characteristics of a signal processor circuit and gain controllers connected before and after the signal processor circuit.

The sixth aspect of the invention is a gain control circuit, characterized in that the circuit comprises a level detector for detecting the output level of the gain controller, a memory section for storing the relationship between the circuit gain control signal amount and the input level of the gain controller, and an AGC controller for adjusting the circuit gain control signal amount so as to maintain a constant signal output of the level detector for gain control as well as referencing the data in the memory section to detect the input level of the gain controller from the circuit gain control signal amount. This aspect has an effect of providing via a simple configuration a gain control circuit which simultaneously provides gain control and input level detection.

The seventh aspect of the invention is a receiver, characterized in that the receiver comprises a gain control circuit comprising a plurality of gain controllers whose temperature characteristics of the gain vary depending on the amount of a circuit gain control signal, a gain control signal generator for outputting a plurality of different gain control signals for controlling the gain of each gain controller, and a gain control circuit which serially connects the plurality of gain controllers and gives a predetermined offset to the plurality of gain control signals. This aspect has an effect of providing via a simple configuration a receiver comprising a gain control circuit having a wide dynamic range and good temperature characteristics.

The eighth aspect of the invention is a receiver, characterized in that the receiver comprises a gain control circuit serially comprising a signal processor circuit which has a gain between a plurality of serially connected gain controllers and which is configured to set via a gain control signal generator the gain of the gain controller in the preceding stage of the signal processor circuit lower than the gain of the gain controller in the subsequent stage of the signal processor circuit. Especially, this aspect has an effect of providing via a simple configuration a receiver comprising a gain control circuit having a wide dynamic range, a high IIP3 and good temperature characteristics.

The ninth aspect of the invention is a receiver, characterized in that the receiver comprises a gain control circuit serially comprising a signal processor circuit which generates different amount of distortion depending on the input level and configured to set via a gain control signal generator the gain of the gain controller in the subsequent stage of the signal processor circuit lower than the gain of the gain controller in the preceding stage of the signal processor circuit. Especially, this aspect has an effect of providing via a simple configuration a receiver comprising a gain control circuit having a wide dynamic range, a low noise figure and good temperature characteristics.

The tenth aspect of the invention is a receiver, characterized in that the receiver comprises a gain control circuit serially comprising a signal processor circuit which has a gain and which generates different amount of distortion depending on the input level between a plurality of serially connected gain controllers and a control signal switching section for switching between setting the gain control signal output from the gain control signal generator so that the gain of the gain controller in the preceding stage of the signal processor circuit becomes lower than the gain of the gain controller in the subsequent stage of the signal processor circuit, and setting the gain control signal output from the gain control signal generator so that the gain of the gain controller in the subsequent stage of the signal processor circuit becomes lower than the gain of the gain controller in the preceding stage of the signal processor circuit. Especially, this aspect has an effect of providing via a simple configuration a receiver comprising a gain control circuit enabling IIP3 and noise figure to be optimized, and having a wide dynamic range and good temperature characteristics.

The eleventh aspect of the invention is a receiver, characterized in that the receiver has a gain control circuit comprising a temperature sensing circuit whose characteristics vary with temperatures, wherein the gain control signal of the gain control signal generator varies with the variation in the output signal of the temperature sensing circuit. Especially, this aspect has an effect of providing via a simple configuration a receiver comprising a gain control circuit having a wide dynamic range and good temperature characteristics.

The twelfth aspect of the invention is a receiver, characterized in that the receiver comprises a gain control circuit comprising a level detector for detecting the output level of the gain controller, a memory section for storing the relationship between the circuit gain control signal amount and the input level of the gain controller, and an AGC controller for adjusting the circuit gain control signal amount so as to maintain a constant signal output of the level detector for gain control as well as referencing the data in the memory section to detect the input level of the gain controller from the circuit gain control signal amount. This aspect has an effect of providing via a simple configuration a receiver comprising a gain control circuit which simultaneously provides gain control and input level detection.

The thirteenth aspect of the invention is a receiver, characterized in that the receiver comprises a gain control circuit comprising an operation section for calculating the input level of a given circuit section from the input level of the gain control circuit and the gain of the circuit section provided in the preceding stage of the gain control circuit. This aspect has an effect of providing via a simple configuration a receiver comprising a gain control circuit which simultaneously provides gain control and input level detection.

The fourteenth aspect of the invention is a transmitter, characterized in that the transmitter comprises a gain control circuit comprising a plurality of gain controllers whose temperature characteristics of the gain vary depending on the amount of a circuit gain control signal and a gain control signal generator for outputting a plurality of different gain control signals for controlling the gain of each gain controller, serially connects the plurality of gain controllers, and gives a predetermined offset to the plurality of gain control signals. This aspect has an effect of providing via a simple configuration a transmitter comprising a gain control circuit having a wide dynamic range and good temperature characteristics.

The fifteenth aspect of the invention is a transmitter, characterized in that the transmitter comprises a gain control circuit serially comprising a signal processor circuit which has a gain between a plurality of serially connected gain controllers and which is configured to set via again control signal generator the gain of the gain controller in the preceding stage of the signal processor circuit lower than the gain of the gain controller in the subsequent stage of the signal processor circuit. Especially, this aspect has an effect of providing via a simple configuration a transmitter comprising a gain control circuit having a wide dynamic range, a high IIP3 and good temperature characteristics.

The sixteenth aspect of the invention is a transmitter, characterized in that the transmitter comprises a gain control circuit serially comprising a signal processor circuit which generates different amount of distortion depending on the input level and configured to set via a gain control signal generator the gain of the gain controller in the subsequent stage of the signal processor circuit lower than the gain of the gain controller in the preceding stage of the signal processor circuit. Especially, this aspect has an effect of providing via a simple configuration a transmitter comprising a gain control circuit having a wide dynamic range, a low noise figure and good temperature characteristics.

The seventeenth aspect of the invention is a transmitter characterized in that the transmitter comprises a gain control circuit serially comprising a signal processor circuit which has a gain and which generates different amount of distortion depending on the input level between a plurality of serially connected gain controllers and a control signal switching section for switching between setting the gain control signal output from the gain control signal generator so that the gain of the gain controller in the preceding stage of the signal processor circuit becomes lower than the gain of the gain controller in the subsequent stage of the signal processor circuit, and setting the gain control signal output from the gain control signal generator so that the gain of the gain controller in the subsequent stage of the signal processor circuit becomes lower than the gain of the gain controller in the preceding stage of the signal processor circuit. Especially, this aspect has an effect of providing via a simple configuration a transmitter comprising a gain control circuit enabling IIP3 and noise figure to be optimized, and having a wide dynamic range and good temperature characteristics.

The eighteenth aspect of the invention is a transmitter, characterized in that the transmitter has a gain control circuit comprising a temperature sensing circuit whose characteristics vary with temperatures, wherein the gain control signal of the gain control signal generator varies with the variation in the output signal of the temperature sensing circuit. Especially, this aspect has an effect of providing via a simple configuration a transmitter comprising a gain control circuit having a wide dynamic range and good temperature characteristics.

The nineteenth aspect of the invention is a transmitter, characterized in that the transmitter comprises a gain control circuit comprising a level detector for detecting the output level of the gain controller, a memory section for storing the relationship between the circuit gain control signal amount and the input level of the gain controller, and an AGC controller for adjusting the circuit gain control signal amount so as to maintain a constant signal output of the level detector for gain control as well as referencing the data in the memory section to detect the input level of the gain controller from the circuit gain control signal amount. This aspect has an effect of providing via a simple configuration a transmitter comprising a gain control circuit which simultaneously provides gain control and input level detection.

The twentieth aspect of the invention is radio apparatus, characterized in that the radio apparatus is composed of a receiver and a transmitter each comprising a gain control circuit including a plurality of gain controllers whose temperature characteristics of the gain vary depending on the amount of a circuit gain control signal and a gain control signal generator for outputting a plurality of different gain control signals for controlling the gain of each gain controller, serially connecting the plurality of gain controllers, and giving a predetermined offset to the plurality of gain control signals. This aspect has an effect of providing via a simple configuration radio apparatus comprising gain control circuits having a wide dynamic range and good temperature characteristics.

The twenty-first aspect of the invention is radio apparatus, characterized in that the radio apparatus is composed of a receiver and a transmitter each comprising a gain control circuit serially including a signal processor circuit which has a gain between a plurality of serially connected gain controllers and which is configured to set via a gain control signal generator the gain of the gain controller in the preceding stage of the signal processor circuit lower than the gain of the gain controller in the subsequent stage of the signal processor circuit. Especially, this aspect has an effect of providing via a simple configuration radio apparatus comprising gain control circuits having a wide dynamic range, a high IIP3 and good temperature characteristics.

The twenty-second aspect of the invention is radio apparatus, characterized in that the radio apparatus is composed of a receiver and a transmitter each comprising a gain control circuit serially including a signal processor circuit which generates different amount of distortion depending on the input level and configured to set via a gain control signal generator the gain of the gain controller in the subsequent stage of the signal processor circuit lower than the gain of the gain controller in the preceding stage of the signal processor circuit. Especially, this aspect has an effect of providing via a simple configuration radio apparatus comprising gain control circuits having a wide dynamic range, a low noise figure and good temperature characteristics.

The twenty-third aspect of the invention is radio apparatus, characterized in that the radio apparatus is composed of a receiver and a transmitter each comprising a gain control circuit serially including a signal processor circuit which has a gain and which generates different amount of distortion depending on the input level between a plurality of serially connected gain controllers and a control signal switching section for switching between setting the gain control signal output from the gain control signal generator so that the gain of the gain controller in the preceding stage of the signal processor circuit becomes lower than the gain of the gain controller in the subsequent stage of the signal processor circuit, and setting the gain control signal output from the gain control signal generator so that the gain of the gain controller in the subsequent stage of the signal processor circuit becomes lower than the gain of the gain controller in the preceding stage of the signal processor circuit. Especially, this aspect has an effect of providing via a simple configuration radio apparatus comprising gain control circuits enabling IIP3 and noise figure to be optimized, and having a wide dynamic range and good temperature characteristics.

The twenty-fourth aspect of the invention is radio apparatus, characterized in that the radio apparatus is composed of a receiver and a transmitter each comprising a gain control circuit including a temperature sensing circuit whose characteristics vary with temperatures, wherein the gain control signal of the gain control signal generator varies with the variation in the output signal of the temperature sensing circuit. Especially, this aspect has an effect of providing via a simple configuration radio apparatus comprising gain control circuits having a wide dynamic range and good temperature characteristics.

The twenty-fifth aspect of the invention is radio apparatus, characterized in that the radio apparatus is composed of a receiver and a transmitter each comprising a gain control circuit including a level detector for detecting the output level of the gain controller, a memory section for storing the relationship between the circuit gain control signal amount and the input level of the gain controller, and an AGC controller for adjusting the circuit gain control signal amount so as to maintain a constant signal output of the level detector for gain control as well as referencing the data in the memory section to detect the input level of the gain controller from the circuit gain control signal amount. This aspect has an effect of providing via a simple configuration radio apparatus comprising gain control circuits which simultaneously provide gain control and input level detection.

The twenty-sixth aspect of the invention is a radio communications system, characterized in that the radio communications system is composed of radio apparatus comprising a gain control circuit including a plurality of gain controllers whose temperature characteristics of the gain vary depending on the amount of a circuit gain control signal and a gain control signal generator for outputting a plurality of different gain control signals for controlling the gain of each gain controller, serially connecting the plurality of gain controllers, and giving a predetermined offset to the plurality of gain control signals. This aspect has an effect of providing via a simple configuration a radio communications system comprising a gain control circuit having a wide dynamic range and good temperature characteristics.

The twenty-seventh aspect of the invention is a radio communications system, characterized in that the radio communications system is composed of radio apparatus comprising a gain control circuit serially including a signal processor circuit which has a gain between a plurality of serially connected gain controllers and which is configured to set via a gain control signal generator the gain of the gain controller in the preceding stage of the signal processor circuit lower than the gain of the gain controller in the subsequent stage of the signal processor circuit. Especially, this aspect has an effect of providing via a simple configuration a radio communications system comprising a gain control circuit having a wide dynamic range, a high IIP3 and good temperature characteristics.

The twenty-eighth aspect of the invention is a radio communications system, characterized in that the radio communications system is composed of radio apparatus comprising a gain control circuit serially including a signal processor circuit which generates different amount of distortion depending on the input level and which is configured to set via a gain control signal generator the gain of the gain controller in the subsequent stage of the signal processor circuit lower than the gain of the gain controller in the preceding stage of the signal processor circuit. Especially, this aspect has an effect of providing via a simple configuration a radio communications system comprising a gain control circuit having a wide dynamic range, a low noise figure and good temperature characteristics.

The twenty-ninth aspect of the invention is a radio communications system, characterized in that the radio communications system is composed of radio apparatus comprising a gain control circuit serially including a signal processor circuit which has a gain and which generates different amount of distortion depending on the input level between a plurality of serially connected gain controllers and a control signal switching section for switching between setting the gain control signal output from the gain control signal generator so that the gain of the gain controller in the preceding stage of the signal processor circuit becomes lower than the gain of the gain controller in the subsequent stage of the signal processor circuit, and setting the gain control signal output from the gain control signal generator so that the gain of the gain controller in the subsequent stage of the signal processor circuit becomes lower than the gain of the gain controller in the preceding stage of the signal processor circuit. Especially, this aspect has an effect of providing via a simple configuration a radio communications system comprising a gain control circuit enabling IIP3 and noise figure to be optimized, and having a wide dynamic range and good temperature characteristics.

The thirtieth aspect of the invention is a radio communications system, characterized in that the radio communications system is composed of radio apparatus comprising a gain control circuit including a temperature sensing circuit whose characteristics vary with temperatures, wherein the gain control signal of the gain control signal generator varies with the variation in the output signal of the temperature sensing circuit. Especially, this aspect has an effect of providing via a simple configuration a radio communications system comprising a gain control circuit having a wide dynamic range and good temperature characteristics.

The thirty-first aspect of the invention is a radio communications system, characterized in that the radio communications system is composed of radio apparatus comprising a gain control circuit including a level detector for detecting the output level of the gain controller, a memory section for storing the relationship between the circuit gain control signal amount and the input level of the gain controller, and an AGC controller for adjusting the circuit gain control signal amount so as to maintain a constant signal output of the level detector for gain control as well as referencing the data in the memory section to detect the input level of the gain controller from the circuit gain control signal amount. This aspect has an effect of providing via a simple configuration a radio communications system comprising a gain control circuit which simultaneously provides gain control and input level detection.

### BRIEF DESCRIPTION OF THE DRAWINGS

Fig. 1 is a block diagram showing the basic configuration of a gain control circuit according to embodiment 1 of the invention.
Fig. 2 is a block diagram showing the basic configuration of a gain control signal generator according to embodiment 1 of the invention.
Fig. 3 shows the temperature characteristics of a gain controller according to embodiment 1 of the invention.

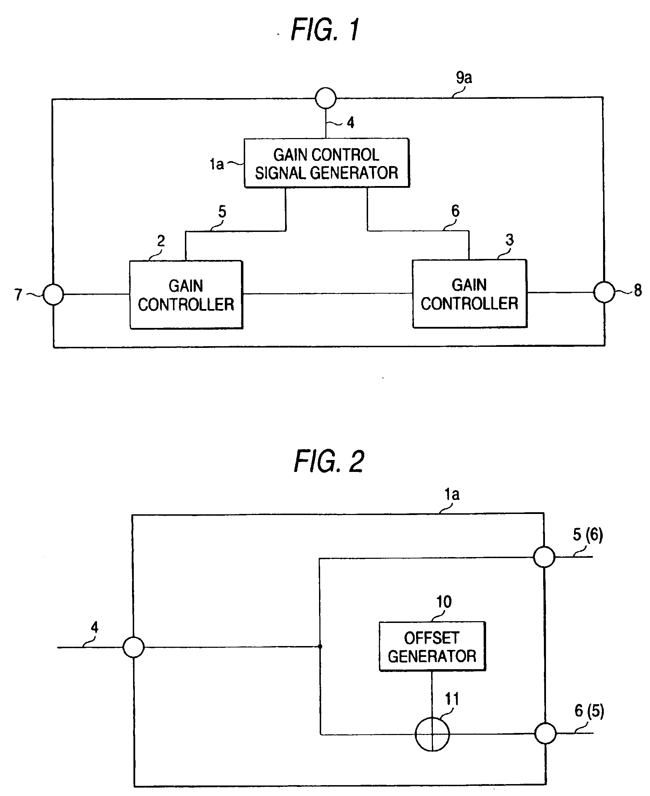

Fig. 2 is a block diagram of an alternative embodiment according to the invention.

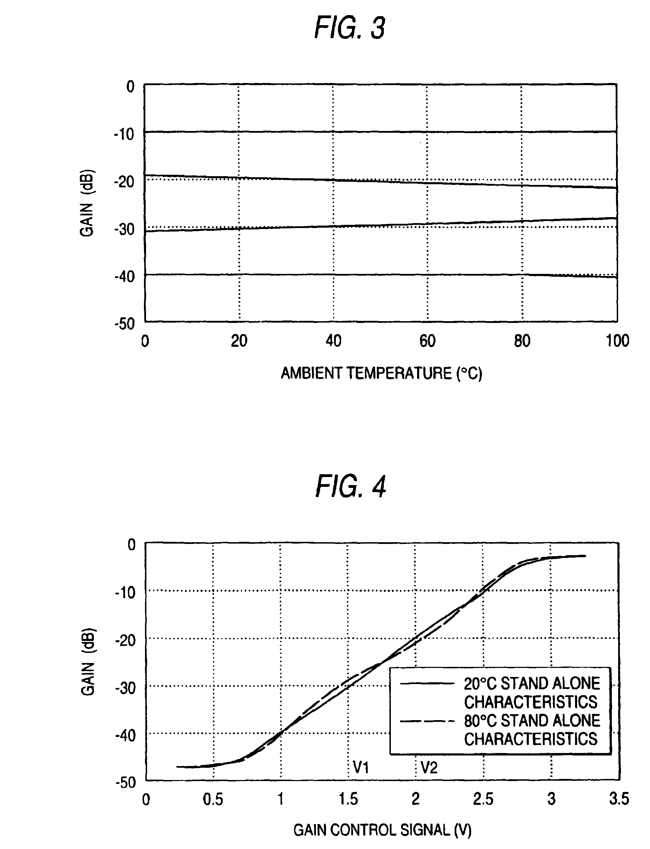

Fig. 3 is a block diagram of an alternative embodiment according to the invention.
Fig. 4 shows gain control signal versus gain characteristics of the gain controller according to embodiment 1 of the invention.

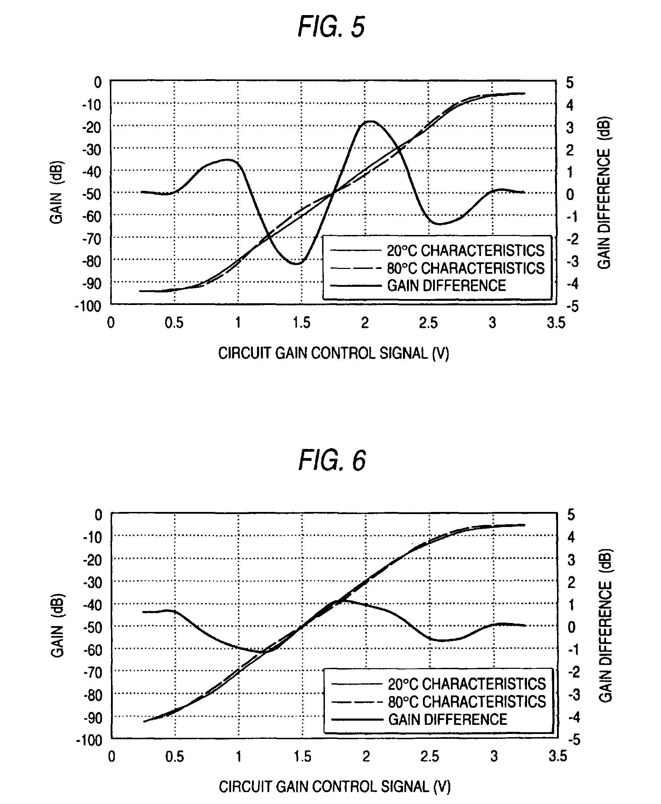

Fig. 5 shows gain control signal versus gain characteristics of the gain control circuit without offset according to embodiment 1 of the invention.
Fig. 6 shows gain control signal versus gain characteristics of the gain control circuit with offset according to embodiment 1 of the invention.

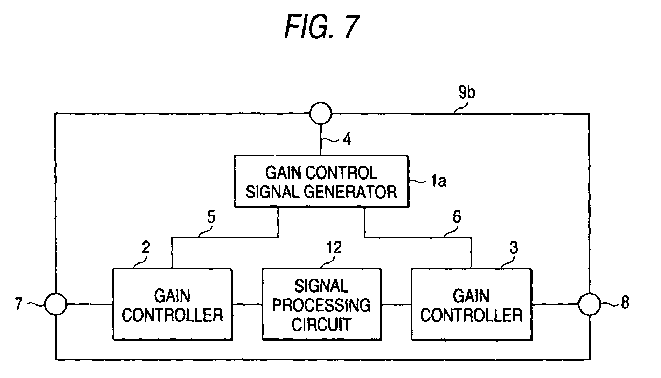

Fig. 7 is a block diagram showing the basic configuration of a gain control circuit according to embodiment 2 of the invention.

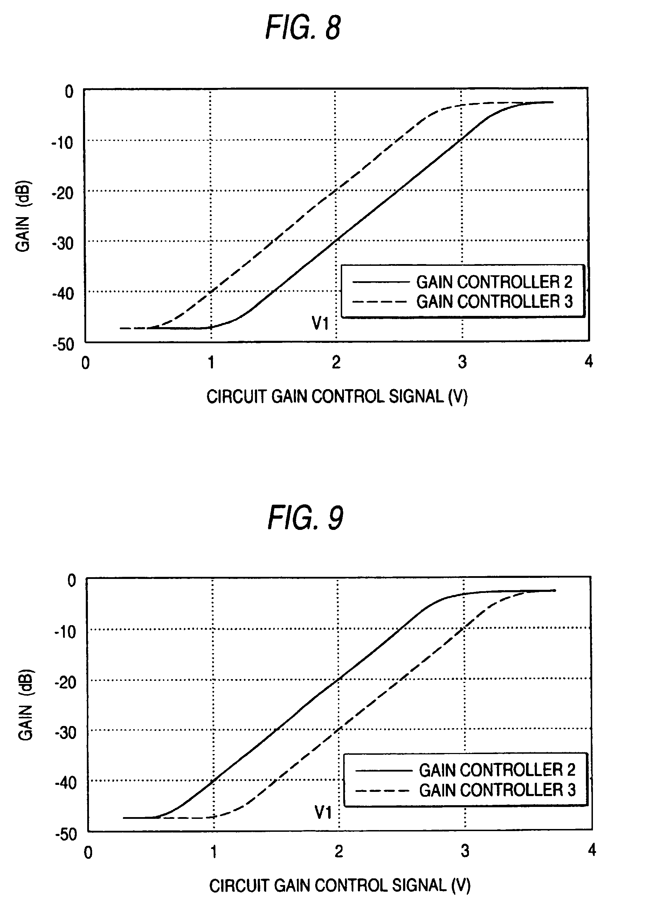

Fig. 8 is a block diagram showing the characteristics of the circuit gain control signal versus gain obtained when the gain of the gain controller of the preceding stage is lower than the gain of the gain controller of the subsequent stage in embodiments 2, 3 of the invention.
Fig. 9 is a block diagram showing the characteristics of the circuit gain control signal versus gain obtained when the gain of the gain controller of the subsequent stage is lower than the gain of the gain controller of the preceding stage in embodiments 2, 3 of the invention.

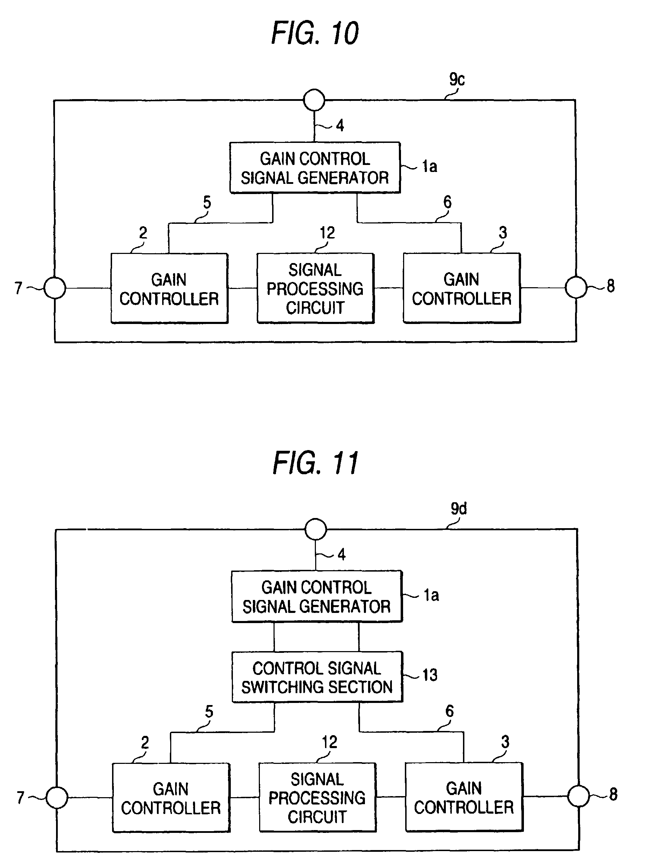

Fig. 10 is a block diagram showing the basic configuration of a gain control circuit according to embodiment 4 of the invention.
Fig. 11 is a block diagram showing the basic configuration of a gain control circuit according to embodiment 4 of the invention.

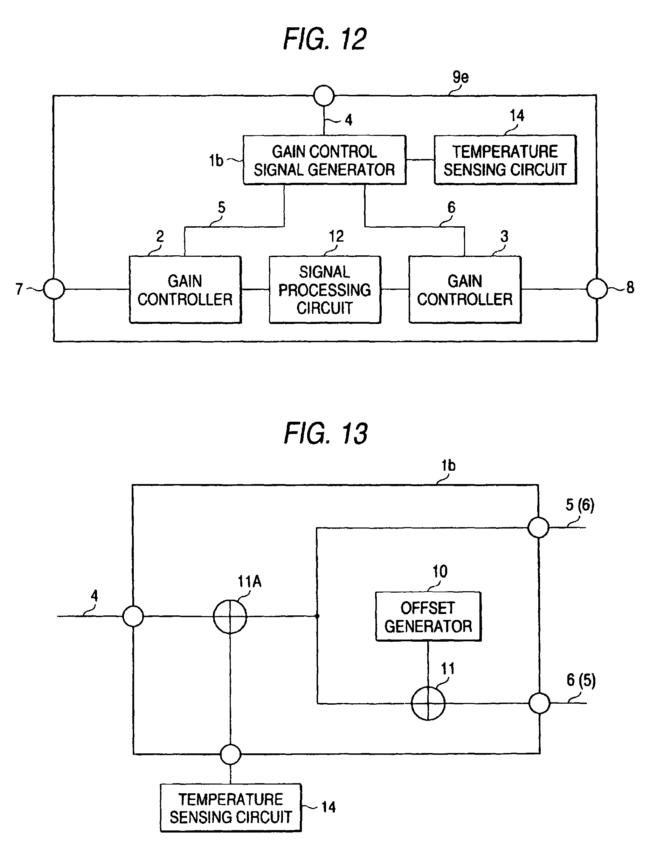

Fig. 12 is a block diagram showing the basic configuration of a gain control circuit according to embodiment 5 of the invention.
Fig. 13 is a block diagram showing the internal configuration of a gain control signal generator according to embodiment 5 of the invention.

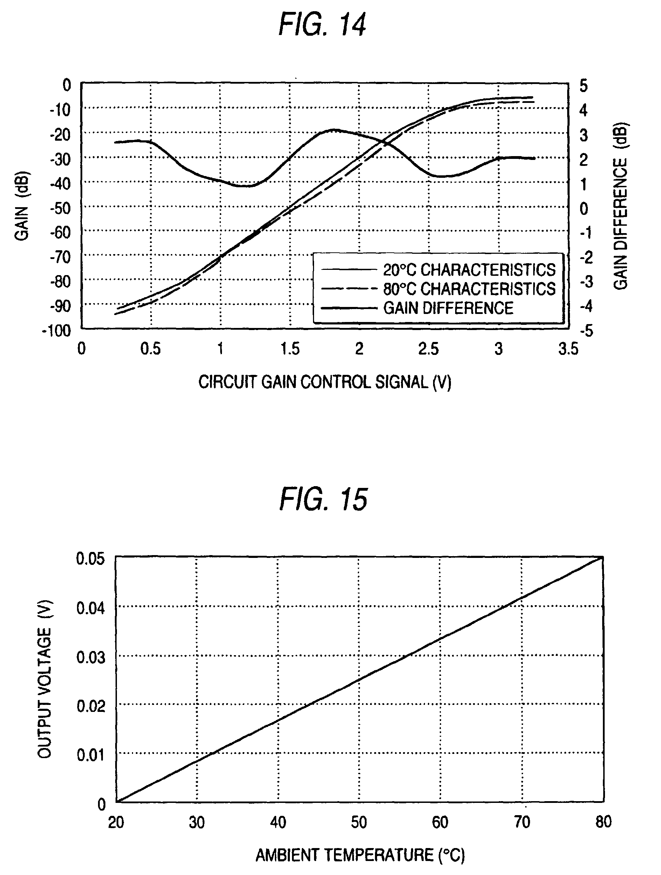

Fig. 14 shows the circuit gain control signal versus gain characteristics of again control circuit without a temperature sensing circuit according to embodiment 5 of the invention.
Fig. 15 shows the temperature versus output voltage characteristics of a temperature sensing circuit according to embodiment 5 of the invention.

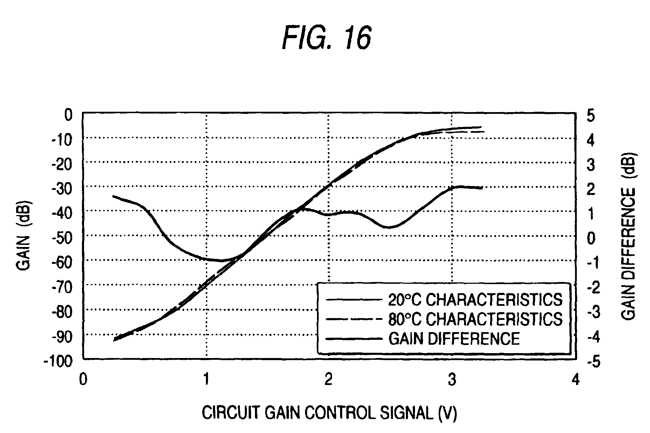

Fig. 16 shows the circuit gain control signal versus gain characteristics of a gain control circuit with a temperature sensing circuit according to embodiment 5 of the invention.

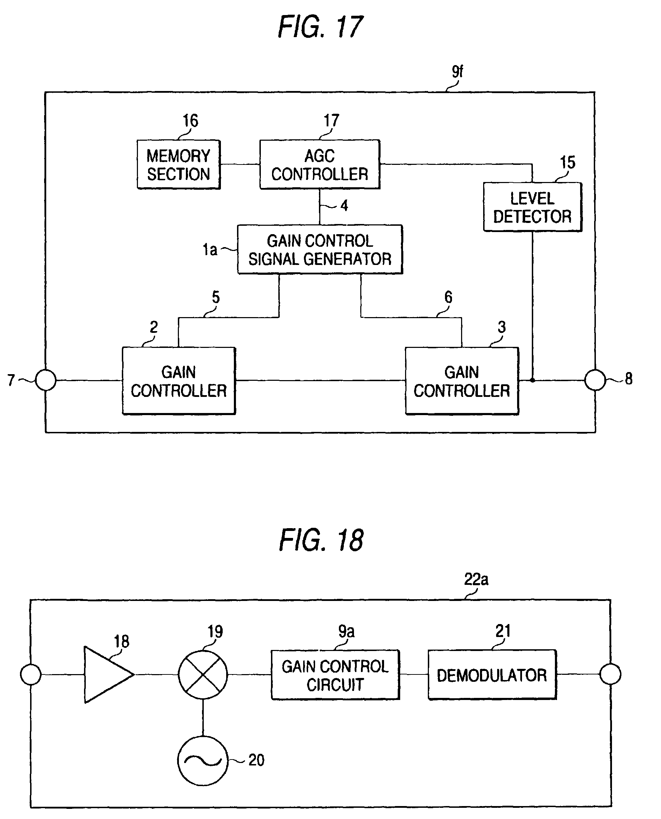

Fig. 17 is a block diagram showing the basic configuration of a gain control circuit according to embodiment 6 of the invention.
Fig. 18 is a block diagram showing the configuration of a receiver comprising a gain control circuit of the invention.

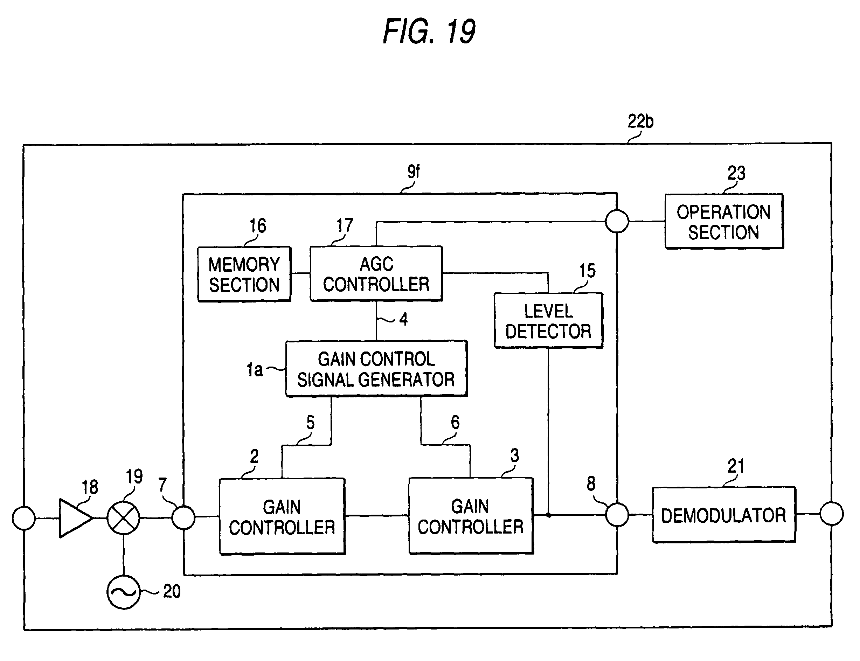

Fig. 19 is a block diagram showing the configuration of a receiver comprising a gain control circuit of the invention.

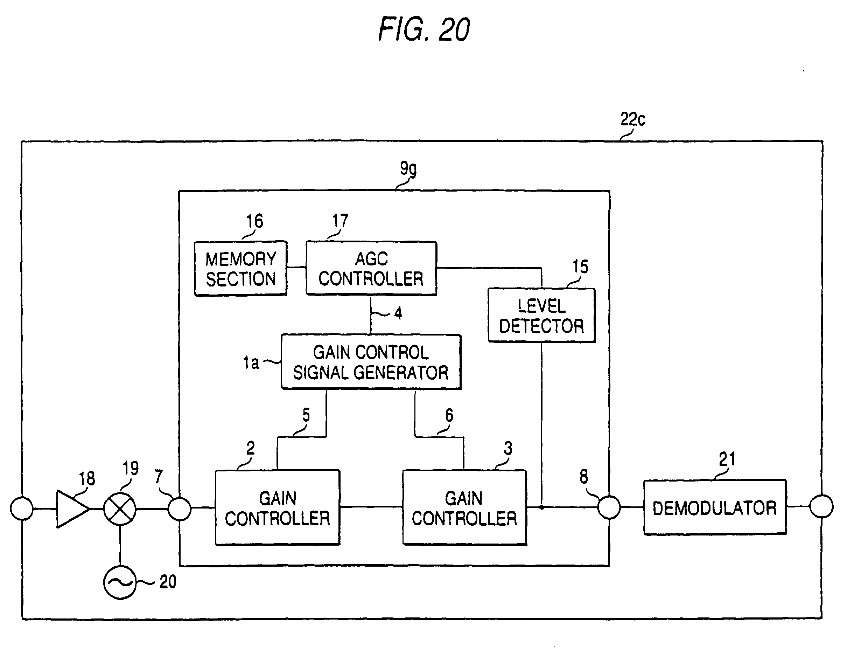

Fig. 20 is a block diagram showing the configuration of a receiver comprising a gain control circuit of the invention.

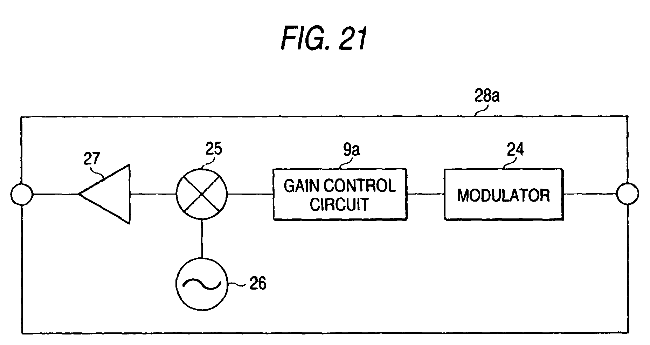

Fig. 21 is a block diagram showing the configuration of a transmitter comprising a gain control circuit of the invention.

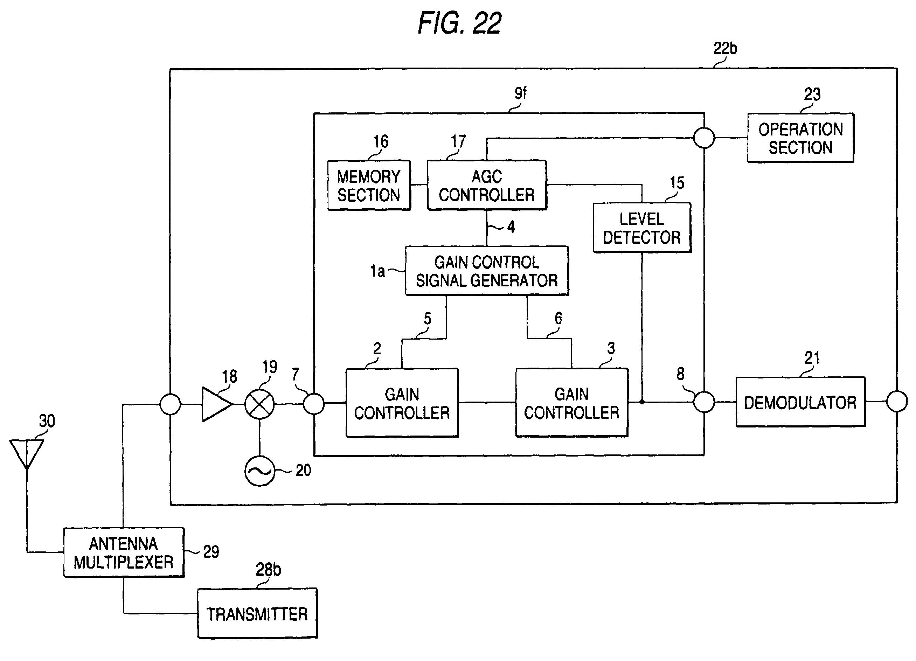

Fig. 22 is a block diagram showing radio apparatus composed of a receiver and a transmitter each comprising a gain control circuit of the invention.
Fig. 23 is a block diagram of a gain control circuit having the conventional level detection feature and AGC feature.

### DETAILED DESCRIPTION OF THE PREFERRED EMBODIMENTS

### (Embodiment 1)

Embodiment 1 of the invention will be described below with reference to Figs. 1 through 6.

Fig. 1 is a block diagram showing the basic configuration of a gain control circuit according to embodiment 1 of the invention. Fig. 2 is a block diagram showing the basic configuration of a gain control signal generator according to embodiment 1 of the invention. Fig. 3 shows the temperature characteristics of a gain controller according to embodiment 1 of the invention. Fig. 4 shows gain control signal versus gain characteristics of the gain controller according to embodiment 1 of the invention. Fig. 5 shows gain control signal versus gain characteristics of the gain control circuit without offset according to embodiment 1 of the invention. Fig. 6 shows gain control signal versus gain characteristics of the gain control circuit with offset according to embodiment 1 of the invention.

In Fig. 1, the gain control circuit 9a comprises a gain control signal generator 1a and gain controllers 2,3. The gain controllers 2 and 3 are serially cascade-connected. The input pin of the gain controller 2 is connected to the input pin 7 of the gain control circuit and the output pin of the gain controller 3 is connected to the output pin 8 of the gain control circuit.

A circuit gain control signal 4 is, e.g., an externally provided control voltage to control the gain of the gain control circuit 9a. The circuit gain control signal 4 is input to the gain control signal generator 1a. A gain control signal 5 output from the gain control signal generator 1a is input to the gain controller 2. A gain control signal 6 output from the gain control signal generator 1a is input to the gain controller 3.

The gain control signal generator 1a, as shown in Fig. 2, comprises an offset generator 10 for outputting a constant signal and an adder 11. The gain control signal generator 1a distributes the circuit gain control signal 4 and outputs one signal to the gain controller 2 (or gain controller 3) as the gain control signal 5 (or gain control signal 6) as well as adds a signal output from the offset generator 10 to the other signal via the adder 11 to output the resulting signal to the gain controller 3 (or gain controller 2) as the gain control signal 6 (or gain control signal 5).

Next, the operation of embodiment 1 of the invention configured as mentioned earlier will be described below.

The gain control signal generator 1a distributes the circuit gain control signal 4 and outputs one signal to the gain controller 2 as the gain control signal 5. The gain control signal generator 1a adds a signal from the offset generator 10 to the other signal and directs the sum output to the gain controller 3 as the gain control signal 6. These gain controllers 2 and 3 are variable attenuators having, e.g., a PIN diode whose gain varies, e.g., within the range from -2dB to -47dB depending on the gain control signals 5 and 6.

In general, a variable attenuator constituting the gain controllers 2 and 3 has temperature characteristics of the gain which vary depending on the gain control signal amount. Such an attenuator has, e.g., temperature characteristics shown in Fig. 3. Fig. 3 is a temperature characteristics diagram representing the ambient temperature (degrees Celsius) on the horizontal axis and the gain (dB) on the vertical axis. As understood from Fig. 3, the gain tends to increase with the rise in the ambient temperature at the gain of about -10dB while the gain tends to decrease with the rise in the ambient temperature at the gain of about -20dB.

Fig. 4 is a characteristics diagram showing the relationship of gain control signal versus gain of the gain controllers 2 and 3 under the ambient temperature of 20 degrees Celsius and 80 degrees Celsius, representing the gain control signal (V) corresponding to the gain control signal 5 or 6 on the horizontal axis and the gain (dB) on the vertical axis. As understood from Fig. 4, the gain under 20 degrees Celsius is smaller than the gain under 80 degrees Celsius by some 1.6dB when the voltage value of the gain control signal is V1. The gain under 20 degrees Celsius is greater than the gain under 80 degrees Celsius by about 1.6dB when the voltage value of the gain control signal is V2.

In embodiment 1 of the invention, the gain controllers 2 and 3 are serially connected in order to secure the gain control range of over 80dB.

Fig. 5 shows the overall gain of the gain control circuit 9a under the ambient temperature of 20 or 80 degrees Celsius wherein the gain controllers 2 and 3 are serially connected, in case the gain control signals 5 and 6 are set to the same voltage value without giving an offset to the gain control signal 5 and 6. Fig. 5 shows an overall gain characteristics diagram representing the circuit gain control signal (V) on the horizontal axis and the gain (dB) and gain difference (dB) on the vertical axis. As understood from Fig. 5, the overall gain range exceeds 90dB while the maximum gain difference under the ambient temperature of 20 and 80 degrees Celsius has increased, doubling the gain difference in Fig. 4 (approximately 3.2dB).

Meanwhile, Fig. 6 shows the overall gain of the gain control circuit 9a under the ambient temperature of 20 or 80 degrees Celsius wherein the gain controllers 2 and 3 are serially connected, in case either the gain control signal 5 or 6 is given an offset of, e.g. 0.5V as a difference between voltage values V1 and V2 as shown in Fig. 4. Fig. 6 shows an overall gain characteristics diagram representing the circuit gain control signal (V) on the horizontal axis and the gain (dB) and gain difference (dB) on the vertical axis. As understood from Fig. 6, the maximum gain difference under the ambient temperature of 20 and 80 degrees Celsius is reduced to about 1.5dB. This offsets the temperature characteristics of gain of the gain control signals 5 and 6. Thus, by giving an offset to the gain control signals 5 and 6, the overall temperature characteristics of the gain control circuit 9a is considerably improved.

AS understood from the above description, the overall temperature characteristics can be improved by giving an offset to either of the two gain control signals in two gain controllers serially connected in order to overlay the area where the gain increases with temperature rise on the area where the gain decreases with temperature rise thus offsetting temperature characteristics.

As mentioned earlier, according to a gain control circuit shown in embodiment 1 of the invention, it is possible to provide a gain control circuit having a wide dynamic range and good temperature characteristics via a simple configuration.

The gain control range value and temperature characteristics value of the gain, and offset value of the invention are not limited to those shown in embodiment 1, but values showing a similar tendency provide similar effects.

While the gain controllers 2, 3 are variable attenuators in embodiment 1, variable gain amplifiers can provide similar effects.

While the gain control signal is a voltage value in embodiment 1, other signal values such as a current value can provide similar effects.

While the gain controllers 2 and 3 have the same characteristics in embodiment 1, gain controllers with different characteristics showing a similar tendency can provide similar effects.

While an offset signal is given to the gain controller 3 in embodiment 1, giving an offset signal to the gain controller 2 can provide similar effects.

The gain control signal generator 1a of the invention is not limited to that shown in Fig. 2 but any other configuration which can give a predetermined offset between gain control signals can provide similar effects.

### (Embodiment 2)

Embodiment 2 of the invention will be described below with reference to Figs. 7 through 9.

Fig. 7 is a block diagram showing the basic configuration of a gain control circuit according to embodiment 2 of the invention. Fig. 8 shows the characteristics of the circuit gain control signal versus gain obtained when the gain of the gain controller of the preceding stage is lower than the gain of the gain controller of the subsequent stage in embodiment 2 of the invention. Fig. 9 shows the characteristics of the circuit gain control signal versus gain obtained when the gain of the gain controller of the subsequent stage is lower than the gain of the gain controller of the preceding stage in embodiment 2 of the invention.

In Fig. 7, same reference numerals are used to designate same components as those in Fig. 1. A gain control circuit 9b comprises a gain control signal generator 1a and gain controllers 2 and 3, same as Fig. 1. The gain controllers 2 and 3 are serially cascade-connected. The input pin of the gain controller 2 is connected to input pin 7 of the gain control circuit and the output pin of the gain controller 3 is connected to the output pin 8 of the gain control circuit. The circuit gain control signal 4 is input to the gain control signal generator 1a. The gain control signal 5 output from the gain control signal generator 1a is input to the gain controller 2. The gain control signal 6 output from the gain control signal generator 1a is input to the gain controller 3.

Embodiment 2 differs from embodiment 1 in that a signal processor circuit 12 is serially connected between the gain controllers 2 and 3 and that the gain control signal generator sets the gain of the gain controller 2 in the preceding stage lower than the gain of the gain controller 3 in the subsequent stage.

Next, the operation of embodiment 2 of the invention configured as mentioned earlier will be described below.

The gain control signal generator 1a distributes the circuit gain control signal 4 into the gain control signal 5 and the gain control signal 6, then outputs the former to the gain controller 2 and the latter to the gain controller 3, respectively. The gain control signal generator 1a gives an offset of, e.g., 0.5V to the gain control signals 5 and 6 so as to set the gain of the gain controller 2 in the preceding stage of the signal processor circuit 12 lower than the gain of the gain controller 3 in the subsequent stage.

Here, the signal processor circuit 12 uses, e.g., an amplifier having a gain of 20dB and IIP3 of +0dBm. IIP3 of the gain controllers 2 and 3 are, e.g., +0dBm or above. The other operations are the same as those of the gain control circuit 9a and thus not discussed here.

Fig. 8 is a characteristics diagram showing the relationship of the circuit gain control signal 4 versus gain of the gain controllers 2 and 3 under the ambient temperature of, e.g., 20 degrees Celsius. In Fig. 8, the gain of the gain controller 2 obtained when the circuit gain control signal 4 is V1 is -30dB and the gain of the gain controller 3 obtained is -20dB. The resulting overall IIP3 of the gain control circuit 9b reaches +30dBm.

Fig. 9 is a characteristics diagram showing the relationship of gain control signal 4 versus gain of the gain controllers 2 and 3 under the ambient temperature of 20 degrees Celsius, obtained when an offset of, e.g., 0.5V is given to the gain control signals 5 and 6 so as to set the gain of the gain controller 2 higher than the gain of the gain controller 3. In Fig. 9, the gain of the gain controller 2 obtained when the circuit gain control signal 4 is V1 is -20dB and the gain of the gain controller 3 obtained is -30dB. The resulting overall IIP3 of the gain control circuit 9b reaches +20dBm.

Thus, in embodiment 2, a high IIP3 can be obtained in the gain control circuit 9b having the signal processing circuit 12, by setting the gain of the gain controller 2 lower than the gain of the gain controller 3. Moreover, it is possible to provide a gain control circuit having a wide dynamic range and good temperature characteristics via a simple configuration.

The gain control range value and temperature characteristics value of the gain, and offset value of the invention are not limited to those shown in embodiment 2, but values showing a similar tendency provide similar effects.

While the gain controllers 2, 3 are variable attenuators in embodiment 2, variable gain amplifiers can provide similar effects.

While the gain control signal is a voltage value in embodiment 2, other signal values such as a current value can provide similar effects.

While the gain controllers 2 and 3 have the same characteristics in embodiment 2, gain controllers with different characteristics showing a similar tendency can provide similar effects.

### (Embodiment 3)

Embodiment 3 of the invention will be described below with reference to Figs. 8 through 10.

Figs. 10 is a block diagram showing the basic configuration of a gain control circuit according to embodiment 3 of the invention.

A gain control circuit 9c in Fig. 10 comprises a gain control signal generator 1a, gain controllers 2 and 3, a gain control circuit input pin 7, a gain control circuit output pin 8, and a signal processor circuit 12, same as Fig. 7. Fig. 10 differs from Fig. 7 in that the gain of the gain controller 2 in the preceding stage of the signal processor circuit 12 is set lower than the gain of the gain controller 3 in the subsequent stage.

Next, the operation of embodiment 3 of the invention configured as mentioned earlier will be described below.

The gain control signal generator 1a distributes the circuit gain control signal 4 into the gain control signal 5 and the gain control signal 6, then outputs the former to the gain controller 2 and the latter to the gain controller 3, respectively. The gain control signal generator 1a gives an offset of, e.g., 0.5V to the gain control signals 5 and 6 so as to set the gain of the gain controller 2 lower than the gain of the gain controller 3. Here, the signal processor circuit 12 uses, e.g., an amplifier having a gain of 20dB and a noise figure of 1dB. The other operations are the same as those of the gain control circuit 9a and thus not discussed here.

Fig. 9 is a characteristics diagram showing the relationship of the circuit gain control signal 4 versus gain of the gain controllers 2 and 3 under the ambient temperature of, e.g., 20 degrees Celsius. In Fig. 9, the gain of the gain controller 2 obtained when the circuit gain control signal 4 is V1 is -20dB and the noise figure obtained is 20dB. The gain of the gain controller 3 obtained is -30dB and the noise figure obtained is 30dB. The resulting overall noise figure of the gain control circuit 9c reaches 30.5dB.

Fig. 8. is a characteristics diagram showing the relationship of gain control signal 4 versus gain of the gain controllers 2 and 3 under the ambient temperature of 20 degrees Celsius, obtained when an offset of, e.g., 0.5V is given to the gain control signals 5 and 6 so as to set the gain of the gain controller 2 lower than the gain of the gain controller 3. In Fig. 8, the gain of the gain controller 2 obtained when the circuit gain control signal 4 is V1 is -30dB and the noise figure obtained is 30dB. The gain of the gain controller 3 obtained is -20dB and the noise figure obtained is 20dB. The resulting overall noise figure of the gain control circuit 9c reaches 33.5dB.

Thus, in embodiment 3, the overall noise figure of the entire gain control circuit 9c can be reduced in the gain control circuit 9c having the signal processing circuit 12, by setting the gain of the gain controller 2 higher than the gain of the gain controller 3. Moreover, it is possible to provide a gain control circuit having a wide dynamic range, a low noise figure and good temperature characteristics via a staple configuration.

The gain control range value and temperature characteristics value of the gain, and offset value of the invention are not limited to those shown in embodiment 3, but values showing a similar tendency provide similar effects. While the gain controllers 2, 3 are variable attenuators in embodiment 3, variable gain amplifiers can provide similar effects.

While the gain control signal is a voltage value in embodiment 3, other signal values such as a current value can provide similar effects.

While the gain controllers 2 and 3 have the same characteristics in embodiment 3, gain controllers with different characteristics showing a similar tendency can provide similar effects.

### (Embodiment 4)

Embodiment 4 of the invention will be described below with reference to Fig. 11.

Fig. 11. is a block diagram showing the basic configuration of a gain control circuit according to embodiment 4 of the invention.

A gain control circuit 9d in Fig. 11 comprises a gain control signal generator 1a, gain controllers 2 and 3, a gain control circuit input pin 7, a gain control circuit output pin 8, and a signal processor circuit 12, same as Fig. 7. Fig. 11 differs from Fig. 7 in that there is provided a control signal switching section 13 for switching between the gain control signals 5 and 6 to be supplied to the gain controllers 2 and 3, between the output pin of the gain control signal generator 1a and the gain control signal input pins of the gain controllers 2 and 3.

Next, the operation of embodiment 4 of the invention configured as mentioned earlier will be described below.

The control signal switching section 13 performs switching operation via an external signal and selectively supplies either of the gain control signals 5 and 6 to the gain controllers 2 or 3. In case the gain of the gain controller 2 is set higher that the gain or the gain controller 3 via the gain control signal 5 or 6 supplied by the switching operation of the control signal switching section 13, a gain control circuit 9d having good distortion characteristics can be provided, as mentioned for embodiment 2. In case the gain of the gain controller 2 is set lower that the gain of the gain controller 3, a gain control circuit 9d having a good noise figure can be provided, as mentioned for embodiment 3.

By switching between the gain control signals 5 and 6 to be supplied to the gain controllers 2 and 3 depending on the signal input level, a gain control circuit 9d having a good noise figure or good distortion characteristics can be provided.

Thus, in embodiment 4, by switching between the gain control signals 5 and 6 to be supplied to the gain controllers 2 and 3 from the gain control signal generator 1a via the control signal switching section 13, optimization of distortion characteristics or noise figure of the gain control circuit can be selectively utilized.

While embodiment 4 uses an external signal to operate the control signal switching section, similar effects can be obtained via a configuration wherein a signal level detector is provided in the gain control circuit for automatic switching depending on the input level of the signal processor circuit 12.

While embodiment 4 uses the control signal switching section 13 for switching between gain control signals, similar effects can be obtained via a gain control signal generator 1a wherein offset switching is allowed, without using the control signal switching section 13.

The gain control range value and temperature characteristics value of the gain, and offset value in the invention are not limited to those shown in embodiment 4, but values showing a similar tendency provide similar effects.

While the gain controllers 2, 3 are variable attenuators in embodiment 4, variable gain amplifiers can provide similar effects.

While the gain control signal is a voltage value in embodiment 4, other signal values such as a current value can provide similar effects.

While the gain controllers 2 and 3 have the same characteristics in embodiment 4, gain controllers with different characteristics showing a similar tendency can provide similar effects.

### (Embodiment 5)

Embodiment 5 of the invention will be described below with reference to Figs. 12 through 16.

Fig. 12 is a block diagram showing the basic configuration of a gain control circuit according to embodiment 5 of the invention. Fig. 13 is a block diagram showing the internal configuration of a gain control signal generator according to embodiment 5 of the invention. Fig. 14 shows the circuit gain control signal versus gain characteristics of a gain control circuit without a temperature sensing circuit according to embodiment 5 of the invention. Fig. 15 shows the temperature versus output voltage characteristics of a temperature sensing circuit according to embodiment 5 of the invention. Fig. 16 shows the circuit gain control signal versus gain characteristics of a gain control circuit with a temperature sensing circuit according to embodiment 5 of the invention.

In Fig. 12, same reference numerals are used to designate same components as those in Fig. 7. The iterative description is omitted and only difference from Fig. 7 is outlined below. A gain control circuit 9e according to embodiment 5 comprises a gain control signal generator 1b, gain controllers 2 and 3, a gain control circuit input pin 7, a gain control circuit output pin 8, and a signal processor circuit 12, and additionally, a temperature sensing circuit 14 for detecting the ambient temperature. The temperature sensing circuit 14 incorporates a temperature sensing element suet as a thermistor and outputs a signal (voltage) dependent on the ambient temperature.

The gain control signal generator 1b, as shown in Fig. 13, comprises an offset generator 10 for outputting a certain signal, an adder 11, and an adder 11A for adding an output signal from the temperature sensing circuit to the circuit gain control signal 4. The gain control signal generator 1b distributes the circuit gain control signal from the adder 11A and outputs one signal to the gain controller 2 (or gain controller 3) as the gain control signal 5 (or gain control signal 6) as well as adds a signal output from the offset generator 10 to the other signal via the adder 11 to output the resulting signal to the gain controller 3 (or gain controller 2) as the gain control signal 6 (or gain control signal 5).

Next, the operation of embodiment 5 of the invention configured as mentioned earlier will be described below.

For example, in case the signal processor circuit 12 has temperature characteristics, temperature characteristics of the gain control circuit 9a are degraded. Temperature characteristics of the signal processor circuit 12 can be compensated for through the procedure: the gain control signals 5 and 6 are compensated for depending on the ambient temperature by adding the temperature signal detected by the temperature sensing circuit 14 to the circuit gain control signal 4 via the adder 11A, then the gain controllers 2 and 3 are controlled by using the resulting gain control signals 5 and 6.

For example, assume that the gain of the signal processor circuit 12 under the ambient temperature of 20 degrees Celsius is 20dB and the gain of the signal processor circuit 12 under the ambient temperature of 80 degrees Celsius is 18dB. Fig. 14 shows the circuit gain control signal versus gain characteristics under the ambient temperatures of 20 degrees celsius and 80 degrees Celsius in the absence of a temperature sensing circuit 14. In Fig. 14, the horizontal axis represents the circuit gain control signal (V) and the vertical axis the gain and the gain difference. As understood from Fig. 14, the gain error will exceed 3dB under the ambient temperatures of 20 degrees Celsius and 80 degrees Celsius in the absence of a temperature sensing circuit 14 within the gain range of -10dB to -80dB.

Fig. 15 shows the relationship between the ambient temperature (degrees Celsius) and the output voltage (V) of the tempearture sensing circuit 14. Fig. 16 shows the circuit gain control signal versus gain characteristics under the ambient temperatures of 20 degrees Celsius and 80 degrees Celsius assumed when the temperature sensing circuit 14 is connected to the gain control circuit 9e as shown in Fig. 12. In Fig. 16, the horizontal axis represents the circuit gain control signal (V) and the vertical axis the gain (dB) and the gain difference (dB). As understood from Fig. 16, the gain error will exceed reach approximately 1dB under the ambient temperatures of 20 degrees Celsius and 80 degrees Celsius in the presence of a temperature sensing circuit 14 within the gain range of -10dB to -80dB.

Thus, by providing a temperature sensing circuit 14 temperature characteristics of the gain control circuit 9e comprising the signal processor circuit having temperature deviation can be improved.

Thus, according to embodiment 5 of the invention, temperature characteristics of the gain control circuit 9e can be improved by modifying the circuit gain control signal via the temperature sensing circuit 14, even when the signal processor circuit 12 has temperature characteristics. Moreover, it is possible to provide a gain control circuit having a wide dynamic range and good temperature characteristics despite the signal processor circuit showing temperature characteristics, via a simple configuration.

While embodiment 5 assumes temperature compensation of the signal processor circuit between the gain controller 2 and the gain controller 3, signal processor circuits connected to the preceding stage and the subsequent stage of the gain controllers 2 and 3 can provide similar effects.

The gain control signal generator 1b of the invention is not limited to that shown in embodiment 5 but any other configuration which adds the output signal from the temperature sensing circuit 14 to the circuit gain control signal 4 and gives a predetermined offset between the gain control signals 5, 6 can provide similar effects.

The gain control range value and temperature characteristics value of the gain, and offset value of the invention are not limited to those shown in embodiment 5, but values showing a similar tendency provide similar effects.

While the gain controllers 2, 3 are variable attenuators in embodiment 5, variable gain amplifiers can provide similar effects.

While the gain control signal is a voltage value in embodiment 5, other signal values such as a current value can provide similar effects.

While the gain controllers 2 and 3 have the same characteristics in embodiment 5, gain controllers with different characteristics showing a similar tendency can provide similar effects.

### (Embodiment 6)

Embodiment 6 of the invention will be described below with reference to Fig. 17.

Fig. 17 is a block diagram showing the basic configuration of a gain control circuit according to embodiment 6 of the invention.

In Fig. 17, same reference numerals are used to designate same components as those in Fig. 1. The iterative description is omitted and only difference from Fig. 1 is outlined below. A gain control circuit 9f according to embodiment 6 comprises a gain control signal generator 1a, gain controllers 2 and 3, a gain control circuit input pin 7, a gain control circuit output pin 8, and additionally, a level detector 15 for detecting the output level of the gain control circuit 9f, a memory section 16 for storing the relationship between the input level of the gain control circuit 9f and a circuit gain control signal 4, and an AGC controller 17 for outputting the circuit gain control signal 4.

The input pin of the level detector 15 is connected to the output pin 8 of the gain control circuit 9f. The output pin of the level detector 15 is connected to the input pin of the AGC controller 17. The memory section 16 is connected to the AGC controller 17 and the output pin of the AGC controller 17 is connected to the input pin of the gain control signal generator 1a.

Next, the operation of the gain control circuit 9f of the invention configured as mentioned earlier will be described below.

The level detector 15 detects the output level of the gain control circuit 9f via, e.g., diode detection to convert the output signal to a voltage value and directs the voltage value to the AGC controller 17. The AGC controller performs gain control to output the circuit gain control signal 4 to the gain control signal generator 1a so as to maintain a constant signal output of the level detector, i.e., the output of the gain control circuit 9f as well as references the data stored in the memory section 16 to detect the input level of the gain control circuit 9f from the circuit gain control signal 4. The operation after the gain control signal generator 1a is the same as that in Fig. 1. The iterative description is omitted.

Thus, according to embodiment 6, a single level detector can perform the operation of maintaining a constant signal output of the gain control circuit 9f and the operation of detecting the input level of the gain control circuit 9f independently of a variation in temperature. Unlike a conventional approach, this eliminates the need for providing a level detector at the input of a gain control circuit and reduces gain losses and circuit size.

While embodiment 6 assumes a configuration wherein the level detector 15, the memory section 16 and the AGC controller 17 are included in the gain control circuit 9f, these components can be provided outside the gain control circuit 9f.

While embodiment 6 assumes a configuration wherein the Level detector 15, the memory section 16 and the AGC controller 17 are incorporated in the gain control circuit according to embodiment 1 shown in Fig. 1, these components can be incorporated in a gain control circuit according to any one of embodiments 2 through 5.

### (Embodiment 7)

Embodiment 7 of the invention will be described below with reference to Fig. 18.

Fig. 18 is a block diagram showing the configuration of a receiver comprising a gain control circuit of the invention. In Fig. 18, a receiver 22a comprises an amplifier 18, a mixer 19, a local frequency generator 20, a gain control circuit 9a, and a demodulator 21.

The amplifier 18 amplifies a received signal then inputs the resulting signal to the mixer 19. The mixer 19 converts the signal received from the amplifier 18 to a signal of a predetermined frequency by mixing the received signal with a local frequency signal coming from the local frequency generator 20, then outputs the resulting signal to the gain control circuit 9a. The gain control circuit 9a adjusts the gain of the frequency-modulated signal to an optimum signal level the outputs the resulting signal to the demodulator 21. The demodulator 21 demodulates the received signal of the optimum signal level and outputs the demodulated data.

In a receiver shown in embodiment 7, it is possible to provide a receiver having a wide dynamic range and good temperature characteristics via a simple configuration, by providing the gain control circuit 9a according to embodiment 1.

While embodiment 7 assumes a configuration wherein the gain control circuit 9a is provided in the subsequent stage of the mixer 19, the gain control circuit 9a can be provided in the preceding stage of the mixer 19.

While embodiment 7 assumes a configuration wherein the preceding stage of the gain control circuit 9a is composed of an amplifier 18, a mixer 19, and a local frequency generator 20, the preceding stage can be composed of a filter, an isolator, and an attenuator.

### (Embodiment 8)

Embodiment 8 of the invention will be described below with reference to Fig. 19.

Fig. 19 is a block diagram showing the configuration of a receiver comprising a gain control circuit of the invention. In Fig. 19, same reference numerals are used to designate same components as those in Fig. 18. A receiver 22b comprises an amplifier 18, a mixer 19, a local frequency generator 20, a gain control circuit 9f of the same configuration as Fig. 17, a demodulator 21, and an operation section 23. The gain control circuit 9f comprises a gain control signal generator 1a, gain controllers 2, 3, a level detector 15, a memory section 16, and an AGC controller 17. The operation section 23 is connected to the AGC controller 17. The output pin of the mixer 19 is connected to the input pin 7 of the gain control circuit 9f. The output pin 8 of the gain control circuit 9f is connected to the demodulator 21.

For the receiver 22b configured as mentioned earlier, only difference from Figs. 17 and 18 is outlined below.

The operation section 23 of embodiment 8 can obtain the input level at an arbitrary section by calculating based on the input level of the gain control circuit 9f and the gain of a circuit provided in the preceding stage of the gain control circuit 9f. For example, the input level of the receiver 22b can be calculated via operation processing.

The AGC controller 17 references the memory section 16 from the circuit gain control signal 4 to read the input level of the gain control circuit 9f. The AGC controller 17 obtains the input level of the receiver 22b through operation processing via the operation section 23.

Thus, in the receiver 22b according to embodiment 8, the gain control circuit 9f comprising a single level detector 15 can perform the operation of maintaining a constant signal output of the gain control circuit 9f and the operation of detecting the input level of the receiver 22b independently of a variation in temperature. Unlike a conventional approach, this eliminates the need for providing a level detector at the input of a gain control circuit and reduces gain losses and circuit size of the receiver 22b. Moreover, it is possible to provide a receiver 22b having a wide dynamic range and good temperature characteristics via a simple configuration.

While embodiment 8 assumes a configuration wherein the gain control circuit 9a is provided in the subsequent stage of the mixer 19, this invention is not limited to this configuration. The same effects are obtained by providing the gain control circuit 9a in the preceding stage of the mixer 19.

While embodiment 8 assumes a configuration wherein the preceding stage of the gain control circuit 9a comprises an amplifier 18, a mixer 19, and a local frequency generator 20, the preceding stage can be further includes a filter, an isolator, and an attenuator.

### (Embodiment 9)

Embodiment 9 of the invention will be described below with reference to Fig. 20.

Fig. 20 is a block diagram showing the configuration of a receiver comprising a gain control circuit of the invention. In Fig. 20, same reference numerals are used to designate same components as those in Fig. 18. A receiver 22c comprises an amplifier 18, a mixer 19, a local frequency generator 20, a gain control circuit 9g of the virtually same configuration as Fig. 17, and a demodulator 21. The gain control circuit 9g comprises a gain control signal generator 1a, gain controllers 2, 3, a level detector 15, a memory section 16, and an AGC controller 17. Difference from Fig. 17 is that the memory section 16 stores data related to the circuit gain control signal 4 and the received input level. The output pin of the mixer 19 is connected to the input pin 7 of the gain control circuit 9g. The output pin 8 of the gain control circuit 9g is connected to the demodulator 21.

For the receiver 22c configured as mentioned earlier, only difference from Figs. 17 and 18 is outlined below.

The AGC controller 17 according to embodiment 9 references the memory section 16 from the circuit gain control signal 4 to read the input level of the receiver 22b.

Thus, in the receiver 22c according to embodiment 9, the gain control circuit 9g comprising a single level detector 15 and no operation section can perform the operation of maintaining a constant signal output of the gain control circuit 9g and the operation of detecting the input level of the receiver 22b independently of a variation in temperature. Unlike a conventional approach, this eliminates the need for providing a level detector at the input of a gain control circuit and reduces gain losses and circuit size of the receiver 22c. Moreover, it is possible to provide a receiver 22c having a wide dynamic range and good temperature characteristics via a simple configuration.

### (Embodiment 10)

Embodiment 10 of the invention will be described below with reference to Fig. 21.

Fig. 21 is a block diagram showing the configuration of a transmitter comprising a gain control circuit of the invention. In Fig. 21, a transmitter 28a comprises a modulator 24, a gain control circuit 9a, a mixer 25, a local frequency generator 26, and an amplifier 27.

The modulator 24 modulates transmission data and inputs the modulated signal to the gain control circuit 9a. The gain control circuit 9a controls the gain of the modulated signal to an optimum signal level and outputs the resulting signal to the mixer 25. The mixer 25 converts the modulated signal to a signal of a predetermined frequency by mixing the modulated signal with a local frequency signal coming from the local frequency generator 26, then outputs the resulting signal to the amplifier 27. The amplifier 27 amplifies the power of the frequency-modulated signal and transmits the resulting signal as a transmission signal.

In a transmitter 28a shown in embodiment 10, it is possible to provide a transmitter having a wide dynamic range and good temperature characteristics via a simple configuration, by providing the gain control circuit 9a according to embodiment 1.

### (Embodiment 11)

Embodiment 11 of the invention will be described below with reference to Fig. 22.

Fig. 22 is a block diagram showing radio apparatus composed of a receiver and a transmitter each comprising a gain control circuit of the invention. In Fig. 22, radio apparatus comprises a receiver 22b of the same configuration as Fig. 19, a transmitter 28a of the same configuration as Fig. 21, an antenna multiplexer 29, and an antenna 30.

The antenna 30 transmits the transmission signal from the transmitter 28b over radio waves and receives incoming radio waves and supplies the radio waves to the receiver 22b. The antenna multiplexer 29 operates so that the transmission signal is not input to the receiver 22b and the received signal is not input to the transmitter 28b.

In the radio apparatus shown in embodiment 11 as mentioned earlier, the input level at the antenna and can be calculated via the operation section 23 of the receiver 22b. This allows easy detection of the input level at the antenna end via a simple configuration. This provides radio apparatus having a wide dynamic range and good temperature characteristics via a simple configuration.

While embodiment 11 assumes a configuration where the received input level is calculated by using the operation section 23, similar effects can be obtained by the use of the memory section 16 for storing the relationship between the circuit gain control signal 4 and the received input level.

It is possible to provide a radio communications system comprising radio apparatus having a wide dynamic range and good temperature characteristics via a simple configuration, by providing the radio communications system with radio apparatus shown in embodiment 11.

The gain control range value and temperature characteristics value of the gain, and offset value of the invention are not limited to those shown in embodiments 2 through 5, but values showing a similar tendency provide similar effects.

As understood from the above description, according to the invention, it is possible to provide a gain control circuit having a wide dynamic range and good temperature characteristics via a simple configuration, by giving an offset to one of the gain control signals in a plurality of gain controllers serially connected in order to overlay the area where the gain increases with temperature rise on the area where the gain decreases with temperature rise thus offsetting temperature characteristics and reducing the overall temperature characteristics.

According to the invention, by setting the gain of the preceding stage lower than the gain of the subsequent stage, or by setting the gain of the subsequent stage lower than the gain of the preceding stage, it is possible to provide a gain control circuit having a wide dynamic range, a good temperature characteristics and excellent distortion characteristics, or a gain control circuit having a wide dynamic range, good temperature characteristics and a low noise figure, via a simple configuration.

According to the invention, by switching over the control signal switching section, optimization of distortion characteristics or noise figure can be selectively utilized. Thus it is possible to provide a gain control circuit having a wide dynamic range and good temperature characteristics via a simple configuration.

According to the invention, by modifying the gain control signal via the temperature sensing circuit, it is possible to provide a gain control circuit having a wide dynamic range and good temperature characteristics via a simple configuration, even when the gain control circuit has temperature characteristics.

According to the invention, it is possible to provide a gain control circuit comprising a single level detector which can perform the operation of maintaining a constant signal output of the gain control circuit and the operation of detecting the input level of the gain control circuit independently of a variation in temperature, via a simple configuration.

According to the invention, it is possible to provide a receiver having a wide dynamic range and good temperature characteristics via a simple configuration.

According to the invention, it is possible to provide a receiver which can perform the operation of maintaining a constant signal output of the gain control circuit and the operation of detecting the input level of the receiver independently of a variation in temperature, via a compact-size and simple configuration.

According to the invention, it is possible to provide a transmitter having a wide dynamic range and good temperature characteristics via a simple configuration.

According to the invention, it is possible to provide radio apparatus having a wide dynamic range and good temperature characteristics via a simple configuration.

According to the invention, it is possible to provide a radio communications system having a wide dynamic range and good temperature characteristics via a simple configuration.

## Claims

1. A gain control circuit comprising:
a gain control signal generator which outputs a plurality of gain control signals to which a predetermined offset is given; and.
a plurality of gain controllers which are serially connected, each gain controller whose temperature characteristics of a gain varies depending on the gain control signal.

2. The gain control circuit according to claim 1, further comprising:
a signal processor circuit having a gain, which is connected between said plurality of gain controllers,
wherein said gain control signal generator sets the gain of the gain controller in the preceding stage of the signal processor circuit lower then the gain of the gain controller in the subsequent stage of the signal processor.

3. The gain control circuit according to claim 1, further comprising:
a signal processor circuit for outputting amount of distortion which varies depending on the input level, which is serially connected between said gain controllers,
wherein said gain control signal generator sets the gain of the gain controller in the subsequent stage of the signal processor circuit lower than the gain of the gain controller in the preceding stage of the signal processor circuit.

4. The gain control circuit according to claim 1, further comprising:
a signal processor circuit having a gain and outputs amount of distortion which varies depending on the input level, which is serially connected between said gain controllers; and
a control signal switching section which switches between setting the gain control signal output from the gain control signal generator so that the gain at the gain controller in the preceding stage of said signal processor circuit becomes lower than the gain of the gain controller in the subsequent stage of said signal processor circuit, and setting the gain control signal output from the gain control signal generator so that the gain of the gain controller in the subsequent stage of the signal processor circuit becomes lower than the gain of the gain controller in the preceding stage of the signal processor circuit.

5. The gain control circuit according to claim 1, further comprising;
a temperature sensing circuit whose characteristics vary with temperatures,
wherein the gain control signal of the gain control signal generator varies with the variation in the output signal of said temperature sensing circuit.

6. The gain control circuit according to claim 1, further comprising:
a level detector which detects the output level of the gain control circuit;
a memory section which stores the relationship between the gain control signal of the gain control signal generator and the input level of said gain control circuit; and
an AGC controller which performs gain control by adjusting a circuit gain control signal so as to maintain a constant signal output of said level detector as well as referencing the data in the memory section to detect the input level of said gain control circuit from the gain, control signal.

7. A receiver comprising a gain control circuit which includes:
a gain control signal generator which outputs a plurality of gain control signals to which a predetermined offset is given; and
a plurality of gain controllers which are serially connected, each gain controller whose temperature characteristics of a gain varies depending on the gain control signal.

8. The receiver according to claim 7,
wherein said gain control circuit further includes a signal processor circuit having a gain, which is connected between said plurality of gain controllers,
wherein said gain control signal generator sets the gain of the gain controller in the preceding stage of the signal processor circuit lower then the gain of the gain controller in the subsequent stage of the signal processor.

9. The receiver according to claim 7,
wherein a signal processor circuit for outputting amount of distortion which varies depending on the input level, which is serially connected between said gain controllers,
wherein said gain control signal generator sets the gain of the gain controller in the subsequent stage of the signal processor circuit lower than the gain of the gain controller in the preceding stage of the signal processor circuit.

10. The receiver according to claim 7, wherein said gain control circuit further includes:
a signal processor circuit having a gain and outputs amount of distortion which varies depending on the input level, which is serially connected between said gain controllers; and
a control signal switching section which switches between setting the gain control signal output from the gain control signal generator so that the gain of the gain controller in the preceding stage of said signal processor circuit becomes lower than the gain of the gain controller in the subsequent stage of said signal processor circuit, and setting the gain control signal output from the gain control signal generator so that the gain of the gain controller in the subsequent stage of the signal processor circuit becomes lower than the gain of the gain controller in the preceding stage of the signal processor circuit.

11. The receiver according to claim 7,
wherein said gain control circuit further includes a temperature sensing circuit whose characteristics vary with temperatures,
wherein the gain control signal of the gain control signal generator varies with the variation in the output signal of said temperature sensing circuit.

12. The receiver according to claim 7, wherein said gain control circuit further includes:
a level detector which detects the output level of the gain control circuit;
a memory section which stores the relationship between the gain control signal of the gain control signal generator and the input level of said gain control circuit; and
an AGC controller which performs gain control by adjusting a circuit gain control signal so as to maintain a constant signal output of said level detector as well as referencing the data in the memory section to detect the input level of said gain control circuit from the gain control signal.

13. A receiver according to claim 7,
wherein said gain control circuit further includes an operation section which calculates the input level of a given circuit section train the input level of the gain control circuit and the gain of the circuit section provided in the preceding stage of said gain control circuit.

14. A transmitter comprising a gain control circuit which includes:
a gain control signal generator which outputs a plurality of gain control signals to which a predetermined offset is given; and
a plurality of gain controllers which are serially connected, each gain controller whose temperature characteristics of a gain varies depending on the gain control signal.

15. The transmitter according to claim 14,
wherein said gain control circuit further includes a signal processor circuit having a gain, which is connected between said plurality of gain controllers,
wherein said gain control signal generator sets the gain of the gain controller In the preceding stage of the signal processor circuit lower then the gain of the gain controller in the subsequent stage of the signal processor.

16. The transmitter according to claim 14,
wherein said gain control circuit further includes a a signal processor circuit for outputting amount of distortion which varies depending on the input level, which is serially connected between said gain controllers,
wherein said gain control signal generator sets the gain of the gain controller in the subsequent stage of the signal processor circuit lower than the gain of the gain controller in the preceding stage of the signal processor circuit.

17. The transmitter according to claim 14, wherein said gain control circuit further includes:
a signal processor circuit having a gain and outputs amount of distortion which varies depending on the input level, which is serially connected between said gain controllers; and
a control signal switching section which switches between setting the gain control signal output from the gain control signal generator so that the gain of the gain controller in the preceding stage of said signal processor circuit becomes lower than the gain of the gain controller in the subsequent stage of said signal processor circuit, and setting the gain control signal output from the gain control signal generator so that the gain of the gain controller in the subsequent stage of the signal processor circuit becomes lower than the gain of the gain controller in the preceding stage of the signal processor circuit.

18. The transmitter according to claim 14,
wherein said gain control circuit further includes a temperature sensing circuit whose characteristics vary with temperatures,
wherein the gain control signal of the gain control signal generator varies with the variation in the output signal of said temperature sensing circuit.

19. The transmitter according to claim 14, wherein said gain control circuit further includes:
a level detector which detects the output level of the gain control circuit;
a memory section which stores the relationship between the gain control signal of the gain control signal generator and the input level of said gain control circuit; and
an AGC controller which performs gain control by adjusting a circuit gain control signal so as to maintain a constant signal output of said level detector as well as referencing the data in the memory section to detect the input level of said gain control circuit from the gain control signal.

20. A radio apparatus comprising a receiver and a transmitter each has a gain control circuit including:
a gain control signal generator which outputs a plurality of gain control signals to which a predetermined offset is given; and
a plurality of gain controllers which are serially connected, each gain controller whose temperature characteristics of a gain varies depending on the gain control signal.

21. The radio apparatus according to claim 20, wherein said gain control circuit further includes a signal processor circuit having a gain, which is connected between said plurality of gain controllers,
wherein said gain control signal generator sets the gain of the gain controller in the preceding stage of the signal processor circuit lower then the gain of the gain controller in the subsequent stage of the signal processor.

22. The radio apparatus according to claim 20,
wherein said gain control circuit includes a signal processor circuit for outputting amount of distortion which varies depending on the input level, which is serially connected between said gain controllers,
wherein said gain control signal generator sets the gain of the gain controller in the subsequent stage of the signal processor circuit lower than the gain of the gain controller in the preceding stage of the signal processor circuit.

23. The radio apparatus according to claim 20, wherein said gain control circuit further includes:.
a signal processor circuit having a gain and outputs amount of distortion which varies depending on the input level, which is serially connected between said gain controllers; and
a control signal switching section which switches between setting the gain control signal output from the gain control signal generator so that the gain of the gain controller in the preceding stage of said signal processor circuit becomes lower than the gain of the gain controller in the subsequent stage of said signal processor circuit, and setting the gain control signal output from the gain control signal generator so that the gain of the gain controller in the subsequent stage of the signal processor circuit becomes lower than the gain of the gain controller in the preceding stage of the signal processor circuit.

24. The radio apparatus according to claim 20,
wherein said gain control circuit further includes a temperature sensing circuit whose characteristics vary with temperatures,
wherein the gain control signal of the gain control signal generator varies with the variation in the output signal of said temperature sensing circuit.

25. The radio apparatus according to claim 20, wherein said gain control circuit further includes:
a level detector which detects the output level of the gain control circuit;
a memory section which stores the relationship between the gain control signal of the gain control signal generator and the input level of said gain control circuit; and
an AGC controller which performs gain control by adjusting a circuit gain control signal so as to maintain a constant signal output of said level detector as well as referencing the data in the memory section to detect the input level of said gain control circuit from the gain control signal.

26. A radio communications system comprising:
a radio apparatus having a gain control circuit including:
a gain control signal generator which outputs a plurality of gain control signals to which a predetermined offset is given; and
a plurality of gain controllers which are serially connected, each gain controller whose temperature characteristics of a gain varies depending on the gain control signal.

27. The radio communications system according to claim 26,
wherein said gain control circuit further includes a signal processor circuit having a gain, which is connected between said plurality of gain controllers,
wherein said gain control signal generator sets the gain of the gain controller in the preceding stage of the signal processor circuit lower then the gain of the gain controller in the subsequent stage of the signal processor.

28. The radio communications system according to claim 26,
a signal processor circuit for outputting amount of distortion which varies depending on the input level, which is serially connected between said gain controllers,
wherein said gain control signal generator sets the gain of the gain controller in the subsequent stage of the signal processor circuit lower than the gain of the gain controller in the preceding stage of the signal processor circuit.

29. The radio communications system according to claim 26, wherein said gain control circuit further includes:
a signal processor circuit having a gain and outputs amount of distortion which varies depending on the input level, which is serially connected between said gain controllers; and
a control signal switching section which switches between setting the gain control signal output from the gain control signal generator so that the gain of the gain controller in the preceding stage of said signal processor circuit becomes lower than the gain of the gain controller in the subsequent stage of said signal processor circuit, and setting the gain control signal output from the gain control signal generator so that the gain of the gain controller in the subsequent stage of the signal processor circuit becomes lower than the gain of the gain controller in the preceding stage of the signal processor circuit.

30. The radio communications system according to claim 26,
wherein said gain control circuit further includes a temperature sensing circuit whose characteristics vary with temperatures,
wherein the gain control signal of the gain control signal generator varies with the variation in the output signal of said temperature sensing circuit.

31. The radio communications system, according to claim 26, wherein said gain control circuit further includes:
a level detector which detects the output level of the gain control circuit;
a memory section which stores the relationship between the gain control signal of the gain control signal generator and the input level of said gain control circuit; and
an AGC controller which performs gain control by adjusting a circuit gain control signal so as to maintain a constant signal output of said level detector as well as referencing the data in the memory section to detect the input level of said gain control circuit from the gain control signal.
